(19) Europäisches Patentamt
European Patent Office
Office européen des brevets

(11) **EP 2 602 807 A1**

(12) **EUROPEAN PATENT APPLICATION**

(43) Date of publication:
**12.06.2013 Bulletin 2013/24**

(51) Int Cl.:
**H01J 37/22** (2006.01)  **H01J 37/28** (2006.01)

(21) Application number: **11192525.1**

(22) Date of filing: **08.12.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **FEI Company**
**Hillsboro, OR 97124-5793 (US)**

(72) Inventors:
• **Faber, Pybe**
  **5612 DV Eindhoven (NL)**

• **Van Leeuwen, Hugo**
  **5644 TH Eindhoven (NL)**
• **Janus, Michael**
  **5251 BK Vlijmen (NL)**

(74) Representative: **Bakker, Hendrik**
  **FEI Company**
  **Patent Department**
  **P.O. Box 1745**
  **5602 BS  Eindhoven (NL)**

(54)  **Adjustment assist tool for charged particle microscope**

(57)  A method of investigating a sample using a charged-particle microscope, comprising the steps of:
- Providing a charged-particle microscope having a particle-optical column and a sample holder;
- Mounting the sample to the sample holder;
- Using the particle-optical column to direct an imaging beam of charged particles at the sample;
- Irradiating the sample with the imaging beam, as a result of which a flux of output radiation is caused to emanate from the sample;
- Capturing at least a portion of said output radiation using a detector;
- Constructing an image of at least a portion of said sample using data output from said detector,

which method comprises the following additional steps:
- Identifying at least one imaging parameter that affects a quality of said image and that can be altered by adjusting an operational setting (O) of the microscope;
- For each such imaging parameter, selecting a quantifiable metric (M) whose value is representative of said imaging parameter;
- For each such metric, rendering in a user interface a value of said metric as a function of said operational setting;
- Using said rendition to manually adjust said operational setting (O) so as to select a particular value (*) of said metric (M) and, accordingly, of the corresponding imaging parameter.

Fig. 2

**Description**

The invention relates to a method of investigating a sample using a charged-particle microscope, comprising the steps of:

- Providing a charged-particle microscope having a particle-optical column and a sample holder;
- Mounting the sample to the sample holder;
- Using the particle-optical column to direct an imaging beam of charged particles at the sample;
- Irradiating the sample with the imaging beam, as a result of which a flux of output radiation is caused to emanate from the sample;
- Capturing at least a portion of said output radiation using a detector;
- Constructing an image of at least a portion of said sample using data output from said detector.

For purposes of clarity and consistency, the following terms as used throughout this text and the appended claims should be interpreted as follows:

- The term "charged particle" refers to an electron or ion (generally a positive ion, such as a Gallium ion or Helium ion, for example).
- The term "microscope" refers to an apparatus that is used to create a magnified image of an object, feature or component that is generally too small to be seen in satisfactory detail with the naked human eye. In addition to having an imaging functionality, such an apparatus may also have a machining functionality; for example, it may be used to locally modify a sample by removing material therefrom ("milling" or "ablation") or adding material thereto ("deposition"). Said imaging functionality and machining functionality may be provided by the same type of charged particle, or may be provided by different types of charged particle; for example, a Focused Ion Beam (FIB) microscope may employ a (focused) ion beam for machining purposes and an electron beam for imaging purposes (a so-called "dual beam" microscope, or "FIB-SEM"), or it may perform machining with a relatively high-energy ion beam and perform imaging with a relatively low-energy ion beam. On the basis of this interpretation, tools such as the following should be regarded as falling within the scope of the current invention: electron microscopes, FIB apparatus, EBID and IBID apparatus (EBID = Electron-Beam-Induced Deposition; IBID = Ion-Beam-Induced Deposition), etc.
- The term "particle-optical column" refers to a collection of electrostatic and/or magnetic lenses that can be used to manipulate a charged-particle beam, serving to provide it with a certain focus or deflection, for example, and/or to mitigate one or more aberrations therein. In addition to (various types of) conventional lens elements, the particle-optical column may also comprise elements such as deflectors, stigmators, aperture (pupil) plates, etc.
- The term "sample holder" refers to any type of table, platform, arm, etc., upon which a sample can be mounted and held in place. Generally, such a sample holder will be comprised in a stage assembly, with which it can be accurately positioned in several degrees of freedom, e.g. with the aid of electrical actuators.
- The term "output radiation" encompasses any radiation that emanates from the sample as a result of its irradiation by the imaging beam. Such output radiation may be particulate and/or photonic in nature. Examples include secondary electrons (SEs), backscattered electrons (BEs), X-rays, visible fluorescence light, and combinations of these. The output radiation may simply be a portion of the imaging beam that is transmitted through or reflected from the sample, or it may be produced by effects such as scattering or ionization, for example.
- The term "detector" should be broadly interpreted as encompassing any detection set-up used to register (one or more types of) radiation emanating from a sample. Such a detector may be unitary, or it may be compound in nature and comprise a plurality of sub-detectors, e.g. as in the case of a spatial distribution of detector units about a sample table, or a pixelated detector. Typical examples of detectors used in CPMs include SE detectors, BE detectors, secondary ion detectors, X-ray detectors, fluorescence detectors, SPM (Scanning Probe Microscopy) detectors, AFM (Atomic Force Microscopy) detectors (which may be regarded as being a type of SPM), etc. Within a particular CPM, a given type of detector may occur singularly or plurally. Generally, a CPM will contain several different types of detector, to allow different types/aspects of output radiation emanating from the sample to be investigated. In addition to detector types whose data output can be used to construct an image (such as those referred to above), one can also employ non-imaging detectors, such as EDS (Energy Dispersive Spectroscopy) detectors, Raman spectroscopes, Auger spectroscopes, etc.

Such concepts will be familiar to the skilled artisan.

In what follows, the invention will - by way of example - often be set forth in the specific context of electron microscopes. However, such simplification is intended solely for clarity/illustrative purposes, and should not be interpreted as limiting.

Electron microscopy is a well-known technique for imaging microscopic objects. The basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" beam of ions, allowing supportive activities such as ion-beam milling or ion-beam-induced deposition, for example. In traditional electron microscopes, the imaging beam is "on" for an extended period of time during a given imaging session; however, electron microscopes are also available in which imaging occurs on the basis of a relatively short "flash" or "burst" of electrons, such an approach being of potential benefit when attempting to image moving samples or radiation-sensitive specimens, for example.

When imaging a sample using a Charged Particle Microscope (CPM), the quality of the obtained image will generally be influenced by various imaging parameters, such as:

- Focus (more specifically, the degree of / deviation from optimum focus);
- Aberrations introduced by the particle-optical column, such as astigmatism (in its various possible forms);
- Distortion,

etc. Such parameters can, in turn, be altered by adjusting certain operational settings of the CPM, such as sample holder position/orientation, electrical excitation(s) applied to one or more components of the particle-optical column (including, for example, one or more stigmators and/or deflectors), electrical potential applied to a sample on the sample holder, density/composition of a gaseous atmosphere present in the vicinity of the sample holder, operating temperature, etc. In typical operation of a traditional CPM, a display device (such as an LCD or CRT screen, for example) is used to display the sample image, a user (operator) of the CPM visually observes this image, and he adjusts one or more of said operational settings while he continually monitors said image to see if it improves or deteriorates accordingly; for example, the user adjusts sample holder position to-and-fro until he achieves what he judges to be a properly focused image. However, such an approach suffers from many drawbacks. For example:

- It is intrinsically subjective.
- It is relatively time consuming, in that an optimal image is generally only obtained after several back-and-forth adjustments of the relevant operational setting through the theoretical point of optimality ("overshoot and replay").
- Such back-and-forth adjustment tends to compound inaccuracies due to any hysteresis effects that might be present. Moreover, it causes the sample to be exposed to an increased cumulative dose of charged particles, which may cause unacceptable damage to the sample before it can be satisfactorily imaged.
- *Inter alia* for the aforementioned reasons, it tends to be relatively inaccurate and to suffer from relatively poor reproducibility.

To address these issues, and more specifically to reduce inaccuracy due to "the human factor", efforts have been made to provide automatic image optimization in CPMs, e.g. by providing autofocus functionality. However, although such approaches may go some way toward alleviating the problems set forth in the previous paragraph, they also tend to create other problems. For instance:

- Autofocus algorithms tend to be "dumb" and "blind", in that they generally cannot take into account relevant information regarding the nature of the sample, the present distance from focus, *etc*. Consequently, they tend to follow a rote approach that may be unnecessarily time-consuming, in that an optimum focus is searched for across a needlessly wide initial range of values. Some algorithms allow the user to "rein in" this range, in an effort to save time; however, this then introduces/increases the risk of a "false positive" being found, i.e. an apparent extremum value that does not represent best focus.
- In the case of a sample with relatively significant topography and a particle-optical column with relatively shallow depth of focus, the question can arise as to precisely what *part* of an image is to be in-focus. Often, autofocus configurations will assume that only a particular pre-defined zone (e.g. the center) of an image is to be optimally focused, with the consequence that a region of potential interest outside this zone will not be sharply imaged.

Such problems are compounded in situations where autofocus functionality is employed as part of automatic batch execution: it is a great annoyance to run an entire batch of measurements only to learn in retrospect that the measurements are essentially worthless due an autofocus error.

*Inter alia* for these reasons, many CPM users consider it unpalatable to have to rely on automatic image optimization.

It is an object of the invention to address these issues. More specifically, it is an object of the invention to provide means by which a CPM image can be reliably optimized in a manner that is more accurate than *via* purely visual inspection of the image and more flexible than *via* automatic image adjustment/optimization.

These and other objects are achieved in a method as specified in the opening paragraph, characterized by the following steps:

- Identifying at least one imaging parameter that affects a quality of said image and that can be altered by adjusting an operational setting of the microscope;
- For each such imaging parameter, selecting a quantifiable metric whose value is representative of said imaging parameter;
- For each such metric, rendering in a user interface a value of said metric as a function of said operational setting;
- Using said rendition to manually adjust said operational setting so as to select a particular value of said metric and, accordingly, of the corresponding imaging parameter.

In research leading to the invention, the inventors realized that a skilled and experienced CPM user will generally provide manual image optimization skills and insights that one will not want to completely forego during CPM operation. On the other hand, being human, the CPM user is inevitably subject to human failings, such as subjectivity, deterioration of judgment with age, injury or fatigue, and lack of precise reproducibility. During tests, the inventors determined that a promising strategy was not to attempt to *replace* the user's image optimization functionality by an automated approach, but instead to *supplement* the former with an aspect of the latter. To this end, the invention allows the CPM user to continue to manually optimize an image, but it provides him with an assistive tool that is quantitative in nature, complements the manual procedure, and allows it to be performed more accurately and efficiently.

The hybrid approach proposed by the current invention is user-discretional: a highly skilled/experienced user may elect to use it only incidentally, for final confirmation, when feeling tired, or for particularly challenging and/or important imaging sessions, whereas a less skilled user may rely on it more heavily and frequently. What is important is that, when a CPM user interface is provided with functionality according to the present invention, the CPM in question has the potential to offer better performance and efficiency under a greater variety of circumstances and in the hands of a larger pool of users.

For purposes of clarity and completeness, it should be noted that the inventive metric rendition need not pertain to an entire image; if desired/required in a particular circumstance, it may also pertain solely to a particular portion of an image.

In a particular embodiment of the current invention, the following applies:

- In addition to said rendition, the user interface *concurrently* displays said image as a function of said operational setting;
- Said manual adjustment step occurs on the basis of user inspection of the behavior of *both* said rendition and said image as a function of varying said operational setting.

If desired, the methodology offered by the present invention allows the CPM user to perform manual image adjustment *solely* on the basis of monitoring the quantitative metric rendered in the user interface; such an approach can, for example, be advantageous in a situation where the CPM is being operated by a remote user *via* a data link, since one need only transmit relatively low-bandwidth numeric metric data between the CPM and the user rather than relatively high-bandwidth image data. However, in the current embodiment, the inventive metric rendition occurs *in addition* to a display of said image, and said manual adjustment occurs *both* on the basis of a visual inspection of the actual image and a monitoring of the rendered metric. Such an approach gives additional confidence in that it allows a cross-check of one approach (e.g. metric monitoring) by the other (e.g. visual image inspection). In particular, many users, although appreciating the improved accuracy and efficiency offered by being able to monitor the rendered numeric metric, will nevertheless feel more comfortable if they can (regularly) verify chosen image parameters by taking a "hands-on" look at the actual image itself.

According to the invention, there are various forms that said rendition can take. For example, it may comprise:

- A graphical display of said metric as a function of said operational setting;
- An acoustic rendition of said metric, whereby a metric value is translated into a corresponding audio pitch caused to emanate from a speaker,

and/or a combination of these two approaches.

The first of these methodologies is perhaps the most versatile, in that it generally offers more possibilities. For example, in the case of a graphical display of said metric, software (which term encompasses firmware, for example) in the CPM can easily calculate and display local slope values (tangent angles) at selected points of the graph in question, and can also highlight points where the calculated slope value is zero - corresponding to the location of suspected extrema or inflection points, for example. The user can then choose to select (or ignore) such a highlighted point.

Alternatively, the software can perform manipulations such as interpolation, extrapolation and/or smoothening/de-noising of the data used as a basis for the graphical representation, and/or can display local error bar values, for example, all such manipulations serving to facilitate the user's interpretation and employment of the displayed graph. The ultimate adjustment is still manual - since it is performed (or not) entirely at the discretion of the user - but the task involved is made easier for the user by employing software to make intelligent suggestions/selections/filters for his consideration. Even if such manipulations are not calculated/displayed together with the graph in question, the very fact that the user is presented with a graph rather than a number train will generally make his manual adjustment task easier, since, by its very nature, a graph tends to be better at revealing data trends, and it tends to appeal more directly to the user's senses, cognition and intuition.

In this discussion of graphical depictions, it should be explicitly noted that the graphical display in question does not have to be a classical "X/Y plot" of an ordinate versus an abscissa. Instead, it may take various other forms, such as a "light bar" depiction (e.g. as used in graphic equalizer displays) - which may or may not use markers to depict maximum/minimum attained metric values in a measurement session, for example. All this having been said, a metric rendition as set forth in the current invention does not have to be graphical *per se*. As already alluded to above, one could just display a number train for the user's perusal. Alternatively, one could employ the acoustic approach referred to above, whereby the numeric metric value is translated into a corresponding audio pitch (tone) that is played from a speaker (which might also take the form of a headphone or earpiece, for example). Such an approach can have merit in that it exploits a different sense (auditory), which, in some individuals or under certain circumstances, may be more finely attuned to identifying local extrema/inflections than the visual sense. There are, for example, individuals who have so-called "perfect pitch hearing", or who have highly augmented auditory sensitivity/resolution as a sensory compensation for some form of visual impairment (such as myopia, strabismus, partial blindness in one eye, etc.); for such individuals, an acoustic rendition of the numeric metric may allow greatly improved accuracy/ease of image adjustment.

Regardless of how the numerical metric value is rendered in the user interface, the underlying data can, if desired, be stored and (subsequently) processed according to need or desire. For example, although one might render a metric as a function of a relevant operational setting, one could also use the associated data to (supplementarily or alternatively) render the metric as a function of elapsed time. Referring to the graphical representation described above, one could, for instance, store graphs for different imaging sessions or image checking procedures, for example, and subsequently recall and process such graphs, e.g. so as to (better) reveal the magnitude, size and possible cause of drift phenomena. Alternatively, one could, for example, compare metric variation data as a function of a first operational setting with corresponding or similar metric variation data as a function of a second (different) operational setting. One might also elect to "zoom in" on a particular set of metric data, e.g. proximal to an extremum. In the context of all such (and similar) possibilities, reference is made to co-pending patent application EP 11187865 (FNL1117), which has certain inventors in common with the current invention.

In a particular embodiment of the current invention, the imaging parameter referred to is selected from the group comprising focus, astigmatism, lens alignment, and combinations hereof. In this regard, the following remarks can be made:

(i) <u>Focus</u>: A sample is said to be "in focus" if the sample is coincident with a focal plane of the particle-optical column. In reality, such a scenario is only attainable by approximation, whence reference can be made to "best focus" or "optimum focus". Such deviation from perfection will, in general, be caused by one or more of the following factors:

- The particle-optical column has a finite depth of focus (depth of field) and the sample is not infinitely thin/flat but, instead, has height/topology. Consequently, only a particular plane within/upon the sample can coincide with said focal plane at any given time.
- The focal plane is itself not flat. Such non-flatness may be caused by effects such as distortion or astigmatism in the particle-optical column, or the particle-optical column may not be (fully) telecentric, for example.

In many everyday applications, one often desires perfect focus, such as in portrait photography or when viewing the night sky through binoculars, for instance. However, in many technical applications, some degree of deliberate de-focus will often be desired, e.g. so as to aid color comparison, or so as to allow foreground/background features to be viewed more sharply than background/foreground features in a scenario involving limited depth of field and significant sample height. It is therefore desirable that, in a CPM, the user should have a final say in the employed (position/degree of) focus in the utilized image.

In general, the degree of focus can be altered by adjusting one or more of the following (operational parameters):

- The sample position with respect to a static focal plane, measured along the optical axis of the particle-optical system (conventionally referred to as the Z-direction). This position can be varied by using an actuator to move the sample table in the $\pm$ Z-direction.

- The position of a dynamic focal plane with respect to a static sample (in the Z-direction). The focal plane can be shifted in Z by appropriate adjustment to one or more optical components in the particle-optical column, e.g. by altering the electrical excitation supplied to such components.
- Adjusting certain physical properties of a medium through which the imaging beam passes on its way to the sample, e.g. by altering the density, composition and/or temperature of a gaseous atmosphere present/introduced between the sample and the particle-optical column.

(ii) Astigmatism: Astigmatism is related to focus, and is a phenomenon whereby (particle-optical) waves propagating within different planes along a common optical axis demonstrate different focal points along that axis. This aberration manifests itself in different forms (orders), such as:

- X/Y (or H/V) astigmatism, involving two of said different planes that are orthogonal to one another when viewed along said optical axis, resulting in two different focal points on that axis.
- Threefold astigmatism, involving three of said different planes that subtend angles of 60° with one another when viewed along said axis, resulting in three different focal points thereon.
- Fivefold astigmatism, similar to threefold astigmatism but now involving five different planes that subtend angles of 36° with one another.

In general, the quantity/nature of astigmatism in a particle-optical system can be adjusted using one or more so-called "stigmators", which are multipole particle-optical elements that can be used to superimpose a corrective field upon the imaging beam. The configuration (and thus effect) of this field can be tuned by varying the electrical excitations supplied to different poles of the stigmator(s).

(iii) Lens alignment: In general, it is desirable for the imaging beam to pass through (or proximal to) the center of the various lenses in the particle-optical column, since such a scenario tends to minimize aberrations. To measure the extent to which such a "paraxial" configuration is achieved, one can deliberately apply a particular (AC) modulation - such as a (quasi-)sinusoidal signal - on top of the (DC) excitation supplied to a given lens element, and observe the resulting image to see if it translates and/or rotates in response to said modulation; in the case of a scanning CPM, such as a SEM or STEM, for example, the applied modulation will preferably have such a form as to present a substantially constant value for the duration of each image-accruing scan, e.g. comprising a waveform that is built up of relatively large-scale "blocks" or "steps". If the imaging beam is ideally paraxial, then no image translation will be observed, and the center of any image rotation will coincide with the center of the image; on the other hand, if the imaging beam is off-center, then one will observe image translation (in the case of an electrostatic lens) and/or image rotation about a non-central point (in the case of a magnetic lens), whereby the magnitude of such motions will be dependent on the extent to which the imaging beam is improperly centered. One or more (X/Y) deflectors can then be used to correct/adjust any observed deviation from optimum centering, by appropriate adjustment of the electrical excitation(s) supplied to said deflector(s).

Image construction in a CPM ultimately boils down to the acquisition of a set $\{I(x,y)\}$ of electrical current values (I) for each co-ordinate position (x,y) in a two-dimensional area (whereby it should be explicitly understood that use of the nomenclature (x,y) does not imply a restriction to Cartesian coordinates - one could just as easily use polar coordinates, for example). This is because, regardless of the type of charged particle employed and/or the type(s) of output radiation emanating from the sample and chosen for detection, the employed detector(s) will ultimately produce an electrical current in response to stimulation by incoming radiation, even though this may involve the use of one or more intermediate/assistive steps, such as the conversion of particulate radiation into photonic radiation using a scintillator material and/or the conversion of photonic radiation into an electrical signal using a photovoltaic cell. Such image construction can occur:

- In a unitary (i.e. single-step) acquisition, as in the case of a TEM, for example. Here, an entire image is formed in one go on a detector such as a CCD array (CCD = Charge-Coupled Device).
- As a result of a scanning/rastering (i.e. multi-step) acquisition, as in the case of a SEM or STEM, for example. Here, the image is built up serially using detector data accrued during a scanning procedure that traverses a given timespan.

Regardless of how it is constructed, the set I(x,y) can be usefully employed by the current invention, as will now be explained.

(a) Focus: Defocusing an image will tend to have the effect of "smearing out" ideally localized values of I across a larger area x*y; consequently, high-gradient peaks and troughs will tend to be smoothened out into relatively low-gradient mounds and shallows. Treating I(x,y) as a mathematical function, it follows that such "smearing out" will affect the value of related functions such as:

$$A(x,y) = \frac{1}{<I>^2} \frac{1}{H*W} \sum_H \sum_W [I(x,y) - <I>]^2$$

$$B(x,y) = \sum_H \sum_W [I(x+1,y) - I(x,y)]^2$$

Here, H and W are the height and width of the image, <I> is the average value of I, and a mathematical product is denoted by the *-symbol. Accordingly, if one plots the values of the functions *A* or *B* as a function of (some operational setting that causes) different focus settings, the resulting plot will show a local extremum (*e.g.* maximum) at best focus. In the context of the current invention, a variable such as *A* or *B* can thus be used as a satisfactory metric for focus optimization purposes.

In addition to these examples, there are many other possible metrics that can be used for focus quantification: see, for example, the various metrics set forth in the article by X.Y. Liu, W.H. Wang and Y. Sun in Journal of Microscopy, Vol. 227, Pt. 1, 2007, pp 15-23, which lists various derivative-based, statistics-based and histogram-based focus metrics employed by the authors in a variety of optical-microscope autofocus trials on specific types of biological tissue samples. The aforementioned functions *A(x,y)* and *B(x,y)* correspond, respectively, to (forms of) the Variance (of pixel intensities) and (squared sum of) the Gradient/Derivative (of the image) alluded to in this article. The skilled artisan will understand that many discretionary modifications/generalizations can be made to the functions *A(x,y)*, *B(x,y)* above and/or to the metrics listed in said article. For example, in the case of function *B(x,y)*, one could additionally consider the derivative in y (not just in *x*) and/or one could elect to apply so-called Gaussian smoothing so as to suppress noise when calculating the derivative, for instance.

As a further possibility, one could also use an approach based on feature edge width measurement, whereby pattern recognition software is used to identify a reference edge in an image, and a width of this edge is determined by measuring the distance (locally perpendicular to the edge) across which the intensity (current) value varies between two reference levels, e.g. 35% of max and 65% of max. When an image is in focus, such an edge width will be smaller than when the same image is out of focus.

(b) <u>Astigmatism</u>: In principle, one can regard the phenomenon of astigmatism as being a convolution of several different focusing issues. Consequently, in attempting to find a suitable metric for the quantification of astigmatism, one can go to work in two different ways:

- One can attempt to de-convolute the problem *ab initio,* by treating it as a superposition of several distinct focusing issues, i.e. by using a technique similar to that set forth above to separately determine the position of best focus for waves propagating in different planes. Determining the (relative) positions of these focal points allows the degree of astigmatism to be quantitatively and qualitatively described.
- One can accept the convoluted nature of the problem and use a mathematical tool that is capable of dealing with this convolution. For example, one can calculate a Fast Fourier Transform (FFT) of function I(x,y). This will generate complex results of the form C = D+iE [i = $\sqrt{(-1)}$], which can be made more tangible by working with the corresponding "power" values F = $\sqrt{(D^2 + E^2)}$.

A specific example of this second approach will now be elucidated in more detail:

(1) The FFT of I (x,y) is calculated, yielding a power spectrum with parametrized power P(r,$\alpha$).
(2) The following two circular integrals are calculated:

$$Gx(r) = \int P(r,\alpha) \sin(N\alpha) \, d\alpha;$$

$$Gy(r) = \int P(r,\alpha) \cos(N\alpha) \, d\alpha,$$

where:

- N is the order of the Astigmatism (e.g. N = 2, 3 and 5, respectively, for the types listed above in item(ii));
- The integrals are calculated over the range $\alpha = 0...2\pi$.

(3) These integrals are themselves integrated, as follows:

$$Gx = \int Gx(r) \, dr;$$

$$Gy = \int Gy(r) \, dr,$$

where:

- The integrals are calculated over the range $r = r_{min}... r_{max}$;
- The delimiting values $r_{min}$ and $r_{max}$ are, respectively, the minimum and maximum values of r for which the previous integrals Gx(r) and Gy(r) have values that extend sufficiently above a defined noise level.

(4) The variables Gx and Gy can be used as metrics in the context of the current invention

As yet another alternative, one could employ a so-called Ronchigram as a metric, e.g. as set forth in the following article:

http://www.esi.nl/publications/condor/Pres8 2009 vdHoeven Alignment STEM MM2009 .pdf

(c) <u>Lens alignment</u>: Referring to item (iii) above, one can record a series S of images S = $I_1$ (x,y), $I_2$ (x,y),...,In (x,y) for different ordinate values $o_1, o_2,...,o_n$ along the modulating signal, and can then attempt to quantify any translational/ rotational differences between members of this series S in different ways. For example, using a procedure such as the following:

- Identifying one or more reference points in a reference member So of S. Such reference points might, for example, be particular features (e.g. sharp corners) identified using image recognition software, or local peaks in intensity.
- Noting the reference position $(x_o, y_o)$ of each such reference point in So.
- In each member $S_m$ of S (other than So), noting the position $(x_m, y_m)$ of the same reference point(s).
- For each such member $S_m$, calculating the positional deviation $(\Delta x_m, \Delta y_m)$ of $(x_m, y_m)$ from $(x_o, y_o)$.
- Calculating the average deviations $<\Delta x_m>$ and $<\Delta y_m>$ considered over all members of S.
  These average deviations can then be used as metrics in the context of the current invention. In such a scenario, and with reference to the above discussion of rendition in the form of a graphical display, one could conceive a useful graphical representation analogous to that employed in a planar spirit level. In such a spirit level, a bubble of gas floats on a body of liquid trapped under a domed, transparent roof, in the middle of which a reference circle is drawn; in use, the planar tilt of the spirit level is then adjusted so as to cause the bubble to move into the reference circle. In a similar manner, the (vectorial) metrics $<\Delta x_m>$ and $<\Delta y_m>$ referred to above could be displayed as points that, by adjustment of appropriate operational settings (e.g. the electrical excitation (s) supplied to one or more deflector elements in the particle-optical column) can be caused to move towards a central "bullseye" reference mark, indicating that the metrics concerned have been zeroed.

As an alternative to the mathematical approach just set forth, one could also use another correlating technique to compare members of the series S. Many such techniques are known from a wealth of publications, and the skilled artisan will be able to choose one or more according to the details of a particular configuration at hand.
As already indicated above, certain types of CPM - such as a SEM or STEM, for example - use a scanning/rastering approach to image acquisition, whereby the image is assembled *serially* using detector data accrued during a scanning procedure. In such a CPM, accumulation of a full image may be quite a time-consuming process (e.g. lasting 1-2 minutes), particularly when the user has indicated that he wants high-quality imagery. In such an instance, instead of rendering a metric "per finished image", one may alternatively elect to render the metric "on-the-fly", i.e. while still constructing the image during the scanning process. Such an approach can lead to a significant improvement in the efficiency with which the CPM is used.

As regards a selected set of imaging parameters and associated metrics that are to be processed in accordance with the current invention, there are many ways in which the constitution of such a set could be determined. For example:

- The user interface (UI) of the CPM might have a menu structure in a window or tab in which the user can pre-select (one or more) imaging parameters $P_n$ whose value he wants to adjust using the method provided by the present invention. In a similar manner, he could choose (one or more) metrics $M_n$ to be used as a basis for "tracking" each of the chosen imaging parameters $P_n$. For example, by using an input device such as a mouse, trackball or touchpad, the user could tick boxes in a list of candidates $P_n$ / $M_n$ presented on a computer display screen. The selected imaging parameters $P_n$ are then tracked via the corresponding metrics $M_n$, which are rendered on the UI in accordance with the invention. If required, the operator can amend his choices $P_n$ / $M_n$ as he wishes.
- Alternatively, one could conceive an automatic approach, in which the CPM itself chooses a set of metrics $M_n$ that (it judges to) allow quickest / most reliable "tracking" of an associated set of imaging parameters $P_n$. One way to do this might be for the CPM to use interpretative software to elect metrics that it considers to give best results in a particular investigation scenario, and to ignore (or demote to a lower ranking) others. The skilled artisan will be well able to implement such scenarios, and to conceive others, such as various hybrids of these approaches.

The invention will now be elucidated in more detail on the basis of exemplary embodiments and the accompanying schematic drawings, in which:

Figure 1 renders a longitudinal cross-sectional view of part of a (particular type of) charged-particle microscope in which a method according to the present invention can be enacted;
Figure 2 renders a screenshot of a display unit comprised in a user interface of a charged particle microscope operated in accordance with an embodiment of the current invention;
Figure 3 renders a longitudinal cross-sectional view of part of another type of charged-particle microscope in which a method according to the present invention can be enacted.

In the Figures, where relevant, corresponding parts are indicated using corresponding reference symbols.

Embodiment 1

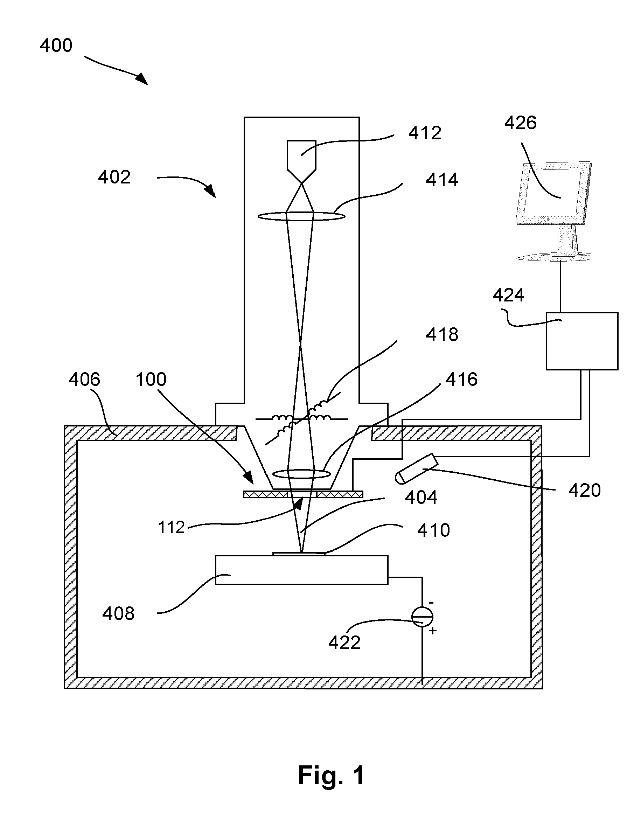

Figure 1 shows a charged-particle microscope (CPM) 400 in which a method according to the current invention can be implemented. In this case, the depicted CPM is a SEM. The microscope 400 comprises a particle-optical column 402, which produces an imaging beam 404 of charged particles (in this case, an electron beam). The particle-optical column 402 is mounted on a vacuum chamber 406, which comprises a sample holder / stage 408 for holding a sample 410. The vacuum chamber 406 is evacuated using vacuum pumps (not depicted). With the aid of voltage source 422, the sample holder 408, or at least the sample 410, may be biased (floated) to an electrical potential with respect to ground.

The particle-optical column 402 comprises an electron source 412, lenses 414, 416 to focus the imaging beam 404 onto the sample 410, and a deflection unit 418. As regards detectors, the apparatus is equipped with:

- A first detector 420, for detecting a first type of stimulated emitted radiation emanating from the sample 410 in response to irradiation by the imaging beam 404. In the present example, the detector 420 is a secondary electron (SE) detector.
- A second detector 100, for detecting a second type of stimulated radiation emitted from the sample 410 in response to irradiation by the imaging beam 404. In the present example, the detector 100 is a segmented electron detector for detecting backscattered electrons (BEs).

As here depicted, the apparatus uses both of these detector types; however, this is purely a design/implementation choice and, if desired, it's also possible to use just one of these detectors types. The apparatus further comprises a computer processing apparatus (controller) 424 for controlling *inter alia* the deflection unit 418, lenses 414, and detectors 420,100, and displaying information gathered from the detectors 420,100 on a display unit 426.

By scanning the imaging beam 404 over the sample 410, stimulated radiation -comprising, for example, SEs and BEs, X-rays and UV/visible-wavelength/IR photons - emanates from the sample 410. As the emitted radiation is position-sensitive (due to said scanning motion), the data output from the detectors 420, 100, will also be position-dependent.

The data obtained from the detectors 420,100 are processed by the processing apparatus 424, and appropriately displayed on display unit 426. Such processing may include operations such as combining, integrating, subtracting, false coloring, edge enhancing, and other processing known to the person skilled in the art. In addition, automated recognition processes, e.g. as used for particle analysis, may be included in such processing. In the case of detectors 420 and 100, the processing apparatus 424 constructs an image of a scanned portion of the sample 410, and displays this on display unit 426.

Many refinements and alternatives of such a set-up will be known to the skilled artisan, including, but not limited to, the detection of (infrared/visible/ultraviolet) light emanating from the sample 410, the use of dual beams (for example an electron beam 404 for imaging and an ion beam for machining (or, in some cases, imaging) the sample 410), the use of a controlled environment at the sample 410 (for example, maintaining a pressure of several mbar - as used in a so-called Environmental SEM - or by admitting gasses, such as etching or precursor gasses), etc.

In accordance with the invention, a CPM such as depicted/described here can be employed as follows.

- A list is provided of imaging parameters $P_n$ that will be manually adjusted by the CPM user with the aid of the invention. As discussed above, the user may provide this list himself, or the CPM may decide it by default.
- Corresponding to each imaging parameter $P_n$, one or more quantitative imaging metrics $M_n$ are elected, whether by the user or by the CPM itself.
- As a specific example, consider the case $P_1$ = focus and $M_1$ = a variable of the type A(x,y) set forth above.
- During a sample investigation (measurement) session, the user will adjust an appropriate operational setting $O_1$ of the CPM in an attempt to optimize $P_1$. For example, he may adjust the Z position of the sample holder 408 along the optical axis of the imaging beam 404, by invoking an actuator to displace the holder 408 or/and by adjusting the electrical excitation supplied to one or more of the lenses 414.
- As the user varies $O_1$, the processing apparatus 424 will calculate the associated value $M_1$ ($O_1$) for each (sampled) value of $O_1$, and will render this in the user interface, e.g. in the form of a visual rendition of a graph of $M_1$ versus $O_1$ on an LCD screen of display unit 426.
- The user monitors said rendition (in the current case, looks at said graph) to determine the value of $O_1$ at which $P_1$ is judged to be optimal, based on the behavior of $M_1$. For example, in the current case where $M_1$ is a variable of said type A(x,y), the user will look for a local extremum (maximum) in said graph, and will note the value of $O_1$ corresponding to that extremum. If desired, one can embody software in the processing apparatus 424 so as to perform some degree of assistive interpretation of said rendition, e.g. by calculating local slope values of said graph and, on the basis thereof, pointing out to the user (e.g. via an arrow, crosshairs, flashing symbol, etc.) a location that is believed to be a local extremum; the user can then elect to follow or ignore any such suggestion as he sees fit.

Although focus was taken as a specific example of an imaging parameter in the example above, one could, of course, alternatively or concurrently elect one or more other imaging parameters, such as astigmatism or lens alignment, for example.

Embodiment 2

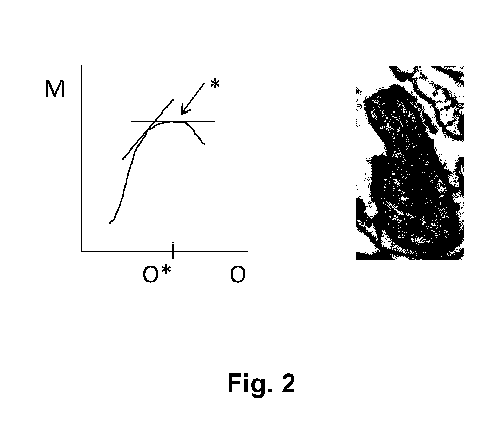

Figure 2 shows a screenshot of a display unit (such as item 426 in Figure 1) comprised in a user interface of a CPM operated in accordance with an embodiment of the current invention. This screenshot comprises:

- On the right, a live image of a portion of a sample being investigated, e.g. a biological cell or a grain structure in a geological sample.
- On the left, a graphical record of the numerical value of a metric M as it varies in response to adjustment of an operational setting O.

In the lead up to this particular screenshot, the CPM user may have adhered to a procedure such as the following:

- Selecting a "start tracking" option from a screen menu, so as to initiate capture/presentation of graphical data. Alternatively, one could enact a set-up whereby a graphical record is automatically captured/presented as soon as the user starts to adjust O (and, for example, is automatically hidden again when O has not been freshly adjusted during a given waiting interval).
- Starting at a relatively low value of O, steadily increasing the value of O and watching the behavior of M as a function of O.
- Once M appears to have reached a definitive (local) maximum value, temporarily stopping variation of O.
- Inspecting the graph of M versus O to decide what precise value of O corresponds to said maximum. In the current case, software in the CPM has calculated the slopes of various tangent lines to the graph, has suggested the location of a suspected maximum using a star (*) symbol, and has indicated the corresponding value of O (O*).

Based on said suggestion or using his own judgment, the CPM user may choose to use the value O* or a value proximal thereto.

Although not required by the invention, the user can confirm his choice by looking at the live image at the right hand side of the screen for the selected value of O, to satisfy himself that it meets with his approval (e.g. is adequately in focus). The image in question may be derived from one or more detectors in the CPM, e.g. it might be provided by an SE detector.

Once the user has performed this manual adjustment to his satisfaction, he can, for example, choose to store or discard the graphical information on the left of the screenshot.

Although only one graph is shown here, the display presented to the CPM user may, of course, comprise several such graphs, corresponding to several different metrics M.

Embodiment 3

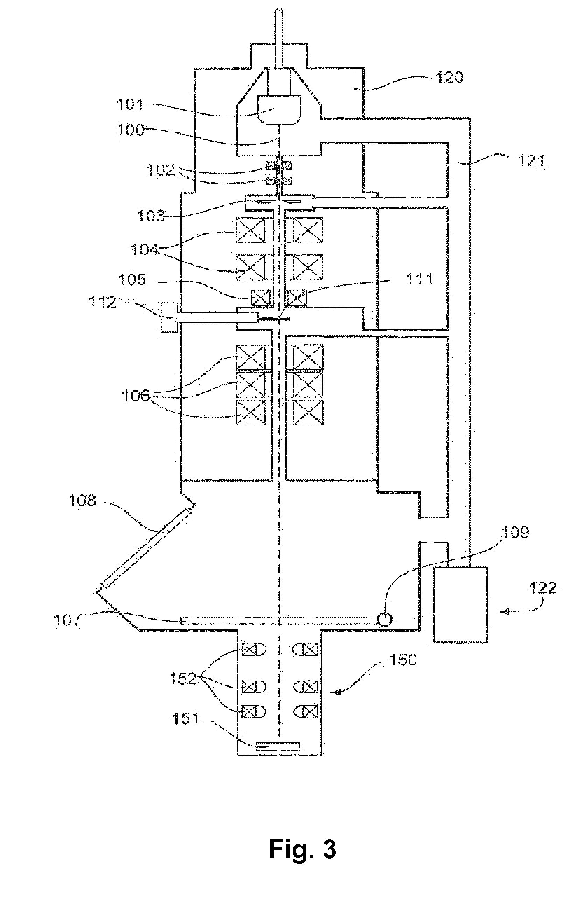

Figure 3 renders a longitudinal cross-sectional view of a particular embodiment of a CPM in which the current invention can be applied. In the present instance, the CPM is a TEM.

The depicted TEM comprises a vacuum housing 120 that is evacuated via tube 121 connected to a vacuum pump 122. A particle source in the form of an electron gun 101 produces a beam of electrons along a particle-optical axis (imaging axis) 100. The electron source 101 can, for example, be a field emitter gun, a Schottky emitter, or a thermionic electron emitter. The electrons produced by the source 101 are accelerated to an adjustable energy of typically 80 - 300 keV (although TEMs using electrons with an adjustable energy of 50 - 500 keV, for example, are also known). The accelerated electron beam then passes through a beam limiting aperture / diaphragm 103 provided in a platinum sheet. To align the electron beam properly to the aperture 103, the beam can be shifted and tilted with the aid of deflectors 102, so that the central part of the beam passes through the aperture 103 along axis 100. Focusing of the beam is achieved using magnetic lenses 104 of the condenser system, together with (part of the) objective lens 105. Deflectors (not depicted) are used to center the beam on a region of interest on a sample 111, and/or to scan the beam over the surface of the sample.

The sample 111 is held by a sample holder 112 in such a manner that it can be positioned in the object plane of objective lens 105. The sample holder 112 may be a conventional type of sample holder for holding a static sample in a containment plane; alternatively, the sample holder 112 can be of a special type that accommodates a moving sample in a flow plane/channel that can contain a stream of liquid water or other solution, for example.

The sample 111 is imaged by a projection system comprising lenses 106 onto fluorescent screen 107, and can be viewed through a window 108. The enlarged image formed on the screen typically has a magnification in the range $10^3$x-$10^6$x, and may show details as small as 0.1 nm or less, for example. The fluorescent screen 107 is connected to a hinge 109, and can be retracted / folded away such that the image formed by the projection system 106 impinges upon primary detector 151. It is noted that, in such an instance, the projection system 106 may need to be re-focused so as to form the image on the primary detector 151 instead of on the fluorescent screen 107. It is further noted that the projection system 106 will generally additionally form intermediate images at intermediate image planes (not depicted).

The primary detector 151 may, for example, comprise a Charge-Coupled Device (CCD) for detecting impinging electrons. As an alternative to electron detection, one can also use a CCD that detects light - such as the light emitted by a Yttrium Aluminium Garnet (YAG) crystal (for example) that is bonded to the CCD, or connected thereto by optical fibres (for example). In such an indirect detector, the YAG crystal emits a number of photons when an electron hits the crystal, and a portion of these photons is detected by the CCD camera; in direct detectors, electrons impinge on the semiconductor chip of the CCD and generate electron/hole pairs, thereby forming the charge to be detected by the CCD chip.

The image formed on the fluorescent screen 107 and on the primary detector 151 is generally aberrated due to (for example) to distortion produced by the lenses 106. To correct such aberrations, multipoles 152 are used, each of which may be a magnetic multipole, an electrostatic multipole or a combination thereof. In the current case, three levels/sets of multipoles are shown; however, a smaller number may also suffice, or, in other cases, a larger number of multipoles may be necessary, in order to correct the distortions with greater accuracy.

It should be noted that Figure 3 only shows a schematic rendition of a typical TEM, and that, in reality, a TEM will generally comprise many more deflectors, apertures, etc. Also, TEMs having correctors for correcting the aberration of the objective lens 105 are known, said correctors typically employing multipoles and round lenses.

Analogous to the situation set forth above in Embodiment 1, the detector 151 in Figure 3 can be connected to a processing apparatus (controller) and display unit [not depicted]. Just as described in the previous Embodiments, such a display unit could be used to graphically depict a chosen metric as a function of a given operational setting, allowing a user to manually adjust an underlying imaging parameter (numerically represented by said metric). For example, the imaging parameter in question might be astigmatism, and the operating parameter in question might be the electrical excitation(s) supplied to one or more the correctional multipoles 152.

**Claims**

1. A method of investigating a sample using a charged-particle microscope, comprising the steps of:

 - Providing a charged-particle microscope having a particle-optical column and a sample holder;
 - Mounting the sample to the sample holder;
 - Using the particle-optical column to direct an imaging beam of charged particles at the sample;
 - Irradiating the sample with the imaging beam, as a result of which a flux of output radiation is caused to emanate from the sample;
 - Capturing at least a portion of said output radiation using a detector;
 - Constructing an image of at least a portion of said sample using data output from said detector, **characterized by** the following steps:
 - Identifying at least one imaging parameter that affects a quality of said image and that can be altered by adjusting an operational setting of the microscope;
 - For each such imaging parameter, selecting a quantifiable metric whose value is representative of said imaging parameter;
 - For each such metric, rendering in a user interface a value of said metric as a function of said operational setting;
 - Using said rendition to manually adjust said operational setting so as to select a particular value of said metric and, accordingly, of the corresponding imaging parameter.

2. A method according to claim 1, wherein:

 - In addition to said rendition, the user interface concurrently displays said image as a function of said operational setting;
 - Said manual adjustment step occurs on the basis of user inspection of the behavior of both said rendition and said image as a function of varying said operational setting.

3. A method according to claim 1 or 2, wherein said rendition is selected from the group comprising:

 - A graphical display of said metric as a function of said operational setting;
 - An acoustic rendition of said metric, whereby a metric value is translated into a corresponding audio pitch caused to emanate from a speaker,
 and combinations hereof.

4. A method according to any of claims 1-3, wherein, in said manual adjustment step, said selected value of said metric corresponds to a value at or proximal to a local extremum or point of inflection in said rendition.

5. A method according to any of claims 1-4, wherein said imaging parameter is selected from the group comprising focus, astigmatism, lens alignment, and combinations hereof.

6. A method according to any of claims 1-5, wherein said image is formed by scanning said imaging beam over the sample.

7. A method according to claim 6, wherein said metric is rendered while constructing said image during scanning.

8. A charged-particle microscope constructed and arranged to perform a method as claimed in any of the claims 1-7.

**Fig. 1**

**Fig. 2**

**Fig. 3**

Europäisches
Patentamt

European
Patent Office

Office européen
des brevets

**EUROPEAN SEARCH REPORT**

Application Number

EP 11 19 2525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HOSOKAWA F ET AL: "On-line alignment system for TEM using a TV and personal computer", ELECTRON MICROSCOPY AND ANALYSIS 1993. PROCEEDINGS OF THE INSTITUTE OF PHYSICS ELECTRON AND ANALYSIS GROUP CONFERENCE IOP PUBLISHING BRISTOL, UK, 1993, pages 531-534, XP9159040, ISBN: 0-7503-0321-2 | 1-5,8 | INV. H01J37/22 H01J37/28 |
| Y | * the whole document * * Chapter 3.2 'Manual alignment'; chapter 5.2 'Manual alignment'; ; figures 1-3 * | 3 | |
| Y | US 2008/073580 A1 (PHANEUF MICHAEL WILLIAM [CA] ET AL) 27 March 2008 (2008-03-27) * abstract * * paragraphs [0061], [0083], [0090], [0097]; figure 7 * | 3 | |
| A | US 2007/064100 A1 (KOBARU ATSUSHI [JP] ET AL) 22 March 2007 (2007-03-22) * abstract * * paragraph [0047]; figure 5 * | 3 | TECHNICAL FIELDS SEARCHED (IPC) H01J |
| A | JP 7 262952 A (JEOL LTD) 13 October 1995 (1995-10-13) * abstract; figures 2,7 * | 1 | |

-/--

~~The present search report has been drawn up for all claims~~

| Place of search | Date of completion of the search | Examiner |
|---|---|---|
| Munich | 12 September 2012 | Lang, Thomas |

EPO FORM 1503 03.82 (P04C01)

Europäisches Patentamt
European Patent Office
Office européen des brevets

# EUROPEAN SEARCH REPORT

Application Number

EP 11 19 2525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KIRKLAND ET AL: "An image and spectrum acquisition system for a VG HB501 stem using a color graphics workstation", ULTRAMICROSCOPY, ELSEVIER, AMSTERDAM, NL, vol. 32, no. 4, 1 May 1990 (1990-05-01), pages 349-364, XP024440132, ISSN: 0304-3991, DOI: 10.1016/0304-3991(90)90081-V [retrieved on 1990-05-01] | 1,2,4,5,8 | |
| Y | * abstract * * page 357, right-hand column, paragraph 2 - page 362, right-hand column, paragraph 1 * | 3 | |
| | ----- | | |
| X | US 2008/283744 A1 (TAKADA SATOSHI [JP] ET AL) 20 November 2008 (2008-11-20) | 1-5,8 | |
| Y | * abstract * * paragraphs [0023] - [0034], [0051] - [0100]; figures 1,4-7 * | 3 | |
| | ----- | | |

TECHNICAL FIELDS SEARCHED (IPC)

~~The present search report has been drawn up for all claims~~

| Place of search | Date of completion of the search | Examiner |
|---|---|---|
| Munich | 12 September 2012 | Lang, Thomas |

EPO FORM 1503 03.82 (P04C01)

Europäisches
Patentamt

European
Patent Office

Office européen
des brevets

Application Number

EP 11 19 2525

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-5, 8

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 11 19 2525

The Search Division considers that the present European patent application does not comply with the
requirements of unity of invention and relates to several inventions or groups of inventions, namely:

1. claims: 1-4, 8(completely); 5(partially)

 A method of investigating a sample using a charged-particle
 microscope, comprising the steps of:  Providing a
 charged-particle microscope having a particle-optical column
 and a sample holder; Mounting the sample to the sample
 holder; Using the particle-optical column to direct an
 imaging beam of charged particles at the sample; Irradiating
 the sample with the imaging beam, as a result of which a
 flux of output radiation is caused to emanate from the
 sample; Capturing at least a portion of said output
 radiation using a detector; Constructing an image of at
 least a portion of said sample using data output from said
 detector; Identifying at least one imaging parameter that
 affects a quality of said image and that can be altered by
 adjusting an operational setting of the microscope; For each
 such imaging parameter, selecting a quantifiable metric
 whose value is representative of said imaging parameter; For
 each such metric, rendering in a user interface a value of
 said metric as a function of said operational setting; Using
 said rendition to manually adjust said operational setting
 so as to select a particular value of said metric and,
 accordingly, of the corresponding imaging parameter (claim
 1);
 wherein said rendition is an acoustic rendition of said
 metric, whereby a metric value is translated into a
 corresponding audio pitch caused to emanate from a speaker
 (claim 3, second alternative)
 ---

2. claim: 5(partially)

 The method according to claims 1, wherein said imaging
 parameter is focus (claim 5, alternative 1)
 ---

3. claims: 6, 7

 The method according to claims 1, wherein said image is
 formed by scanning said imaging beam over the sample.
 ---

**ANNEX TO THE EUROPEAN SEARCH REPORT
ON EUROPEAN PATENT APPLICATION NO.**

EP 11 19 2525

This annex lists the patent family members relating to the patent documents cited in the above-mentioned European search report.
The members are as contained in the European Patent Office EDP file on
The European Patent Office is in no way liable for these particulars which are merely given for the purpose of information.

12-09-2012

| Patent document cited in search report | | Publication date | Patent family member(s) | | Publication date |
|---|---|---|---|---|---|
| US 2008073580 | A1 | 27-03-2008 | NONE | | |
| US 2007064100 | A1 | 22-03-2007 | JP | 4621098 B2 | 26-01-2011 |
| | | | JP | 2007080670 A | 29-03-2007 |
| | | | US | 2007064100 A1 | 22-03-2007 |
| JP 7262952 | A | 13-10-1995 | JP | 3195708 B2 | 06-08-2001 |
| | | | JP | 7262952 A | 13-10-1995 |
| US 2008283744 | A1 | 20-11-2008 | JP | 2008181786 A | 07-08-2008 |
| | | | US | 2008283744 A1 | 20-11-2008 |

**EP 2 602 807 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 11187865 A


**Non-patent literature cited in the description**

- **X.Y. LIU ; W.H. WANG ; Y. SUN.** *Journal of Microscopy,* 2007, vol. 227, 15-23